# FASCICULE DE BREVET EUROPEEN

(11) **EP 1 009 040 B1**
(45) Date de publication et mention de la délivrance du brevet: **12.02.2003**
(21) Numéro de dépôt: 99403047.6
(22) Date de dépôt: 07.12.1999
(51) Int. Cl.: H01L 41/09

(54) **Actionneurs à matériau actif piézo-électrique ou électrostrictif**
Antrieb aus aktivem, piezoelektrischem oder elektrostriktivem Material
Actuators of active piezoelectric or electrostrictive material

(30) Priorité: 07.12.1998 FR 9815437
(43) Date de publication de la demande: 14.06.2000
(73) Titulaire: SAGEM S.A., 75116 Paris (FR)
(72) Inventeur: Groult, Bartélémy, 75015 Paris (FR); Charrier, Jean-Claude, 91210 Draveil (FR)
(74) Mandataire: Schrimpf, Robert

(56) Documents cités:
- EP-A- 0 516 175
- US-A- 5 001 382

## Description

La présente invention est relative à des actionneurs à matériau actif piézo-électrique ou électrostrictif.

Elle trouve avantageusement application pour la réalisation de commandes de vol primaires ou secondaires d'aéronefs.

Pour diverses raisons (maintenance, pollution, risque d'incendie, etc.), il est souhaitable de réduire la part de l'hydraulique dans la commande de vol au profit de commandes électriques.

Or, la technologie qui consiste à utiliser des moteurs électromagnétiques associés à des moyens formant réducteur conduit à des équipements dont la masse est trop élevée.

Pour pallier les inconvénients des moteurs électromagnétiques, il a déjà été proposé d'utiliser des moteurs à base de matériaux piézo-électriques ou électrostrictifs aptes à présenter des densités d'énergie élevées et capables de supporter de fortes contraintes, tels que des moteurs à vibrations ou des actionneurs à amplificateurs.

On pourra à cet égard avantageusement se référer à :
« Actionneurs - Des matériaux piézo-électriques pour les commandes du futur » - Usine nouvelle - 31 octobre 1996 - n°2568
« Des commandes de vol piézo-électriques » - Air et Cosmos/Aviation International - n°1602 - 28 février 1997
« A new amplifier piezoelectric actuator for precise positioning and semi-passive damping »- R. Le Letty, F. Claeyssen, G. Thomin - 2^{nd} space microdynamics and accurate control symposium - 13-16 Mai 1997 - Toulouse.

Toutefois, les solutions dont il est fait état dans ces publications ne sont pas satisfaisantes.

Notamment, les moteurs à vibrations ne peuvent être utilisés pour réaliser des commandes primaires, étant donné que le fonctionnement permanent conduit à une usure trop rapide de l'interface et au maintien de la dernière position en cas de coupure de l'énergie.

Quant aux actionneurs à amplificateurs, ils nécessitent des structures de conversion massives, ce qui réduit considérablement l'avantage initial de légèreté et de densité d'énergie.

Un but de l'invention est de proposer une structure d'actionneur piézo-électrique ou électrostrictif qui est rigide, légère et qui permet de convertir les petits déplacements piézo-électriques ou électrostrictifs élémentaires en grands déplacements.

Bien que n'étant pas à prendre en considération pour l'appréciation de l'activité inventive de l'invention qui va être décrite, puisque publiée après la date de dépôt de la présente invention, il convient de citer la demande de brevet antérieure EP 0 908 961 A1 au nom de la société demanderesse pour mieux comprendre l'invention ici en objet.

Cette demande décrit un actionneur qui comporte une pluralité d'empilements de blocs élémentaires en un matériau actif piézo-électrique ou électrostrictif qui sont juxtaposés de façon à former une structure tubulaire constituée d'une superposition de couches de blocs de matériau actifs qui d'une couche à l'autre sont d'une polarisation différente.

Des bandes de séparation - qui sont réparties sur toute la périphérie de la structure et qui s'étendent chacune sur toute la hauteur de celle-ci-séparent deux à deux les blocs élémentaires successifs des couches de la structure. Chaque bande de séparation est elle-même constituée d'une pluralité d'éléments de séparation superposés dans la hauteur de la structure. Ces éléments de séparation s'étendent chacun à travers deux couches de blocs actifs et sont aptes à glisser les uns sur les autres. Ils sont d'une raideur supérieure à celle des blocs élémentaires en matériau actif. Ces bandes de séparation sont par exemple constituées par des bandes métalliques présentant des fentes réparties dans leur hauteur, ces fentes séparant les éléments de séparation successifs.

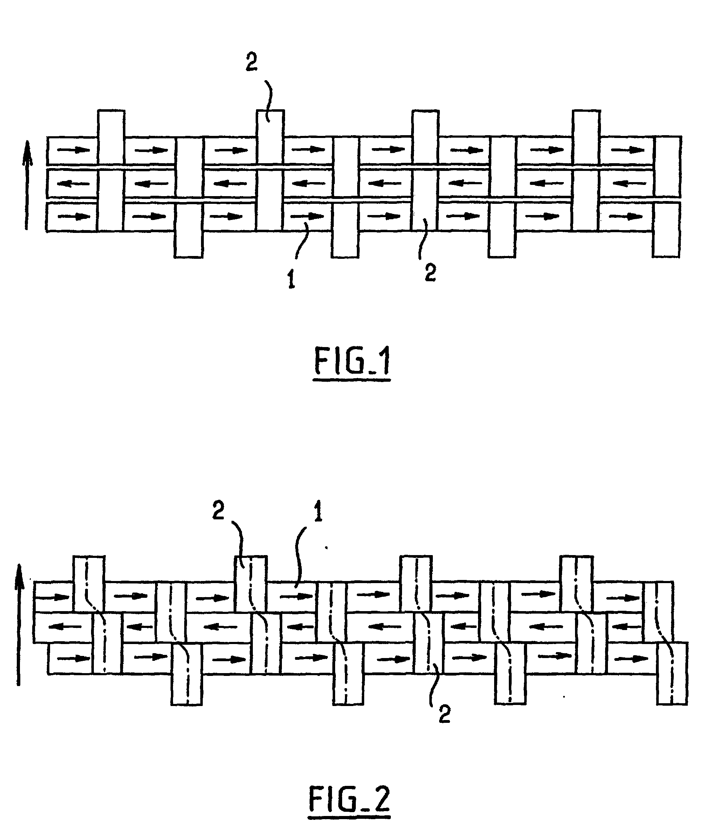

A titre illustratif, une structure de ce type a été représentée sous forme développée sur la figure 1. Sur cette figure, les blocs élémentaires en matériau actif ont été référencés par 1, les éléments de séparation par 2. Les flèches dans les blocs 1 indiquent les sens de polarisation.

Avec une telle structure, on obtient une déformation en torsion de l'actionneur sous l'effet de l'application d'une tension de signe alterné sur les bandes métalliques de séparation.

C'est ce qu'illustre la figure 2.

Cette déformation en torsion peut aller jusqu'à 15°, voir être supérieure.

La réalisation d'un tel actionneur nécessite la précontrainte des céramiques qui constituent les blocs actifs.

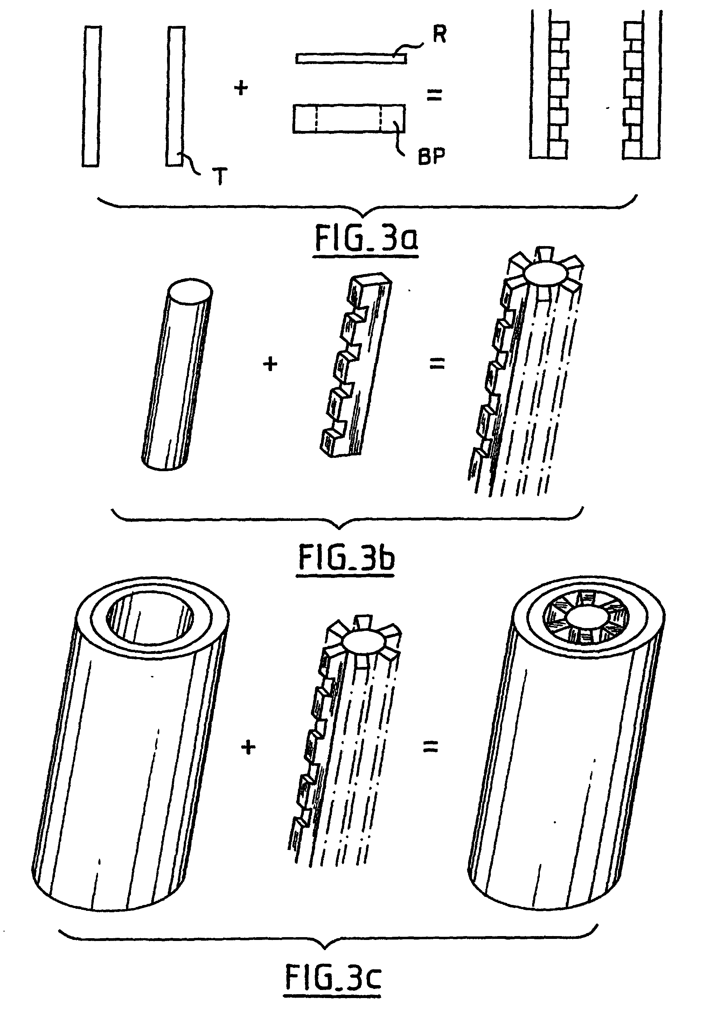

Dans la solution proposée par la demande de brevet précitée, cette précontrainte était réalisée par des bagues en un alliage à mémoire de forme isolées électriquement les unes des autres afin d'éviter tout court-circuit. Le montage se fait alors de la façon illustrée sur les figures 3a à 3c :
- on empile à basse température dans un tube externe T une alternance de bagues de précontrainte BP et de rondelles isolantes R (figure 3a);
- on colle le long des génératrices d'un noyau interne cylindrique N des bandes de séparation métalliques fendues ;
- on introduit le noyau et les bandes dans le tube formé par les rondelles de précontrainte ;
- dans les logements ainsi définis entre les bagues, les bandes et le noyau, on introduit des blocs de céramique 1 ;
- on chauffe l'ensemble de façon à provoquer un changement de phase des bagues de précontrainte BP, lesdites bagues exerçant alors un effort sur les bandes métalliques.

Toutefois, une telle mise en oeuvre pose plusieurs problèmes techniques.

Elle s'avère difficilement compatible avec des tolérances de fabrication classiques sur des céramiques. Notamment, la réalisation des céramiques avec la tolérance qui serait nécessaire pour que les bandes métalliques et les blocs de céramique soient parfaitement interfacés, de façon à disposer de niveaux de précontraintes fiables et contrôlables, s'avère délicate et engendrerait un surcoût important.

En outre, les bagues de précontrainte sont à l'origine d'un surpoids qui est pénalisant pour le tube actionneur.

Egalement, le fait de travailler avec des matériaux à mémoire de forme est à l'origine de problèmes particuliers liés au comportement hyperélastique de ces matériaux et au déplacement de leur palier hyperélastique en fonction de la température.

Un but de l'invention est de pallier ces inconvénients.

A cet effet, l'invention propose un actionneur piézo-électrique ou électrostrictif, qui comporte une pluralité d'étages de blocs actifs piézo-électriques ou électrostricifs répartis de façon à former une structure tubulaire, la polarisation des blocs actifs étant alternée d'un étage à l'autre, des éléments de séparation séparant deux à deux les blocs actifs élémentaires d'un même étage, ces éléments étant superposés les uns aux autres dans la hauteur de la structure, étant aptes à glisser les uns sur les autres et étant d'une raideur supérieure à celle des blocs actifs élémentaires, un élément de séparation s'étendant sur la hauteur de deux étages de blocs actifs, les éléments de séparation de part et d'autre d'un même bloc actif élémentaire s'étendant respectivement à travers l'un et l'autre des deux étages de part et d'autre dudit bloc actif élémentaire, un élément de séparation étant constitué de deux pavés soudés appartenant chacun à un étage différent, les pavés d'un même étage étant alternativement des pavés qui sont d'une pièce avec une structure de précontrainte qui s'étend à l'intérieur dudit étage et des pavés soudés aux pavés de l'étage précédent qui sont d'une pièce avec la structure de précontrainte de cet autre étage, et des moyens formant électrodes permettant d'appliquer des tensions alternées sur les différents empilements de blocs actifs.

L'invention propose également un procédé pour la réalisation d'un tel actionneur piézo-électrique ou électrostrictif qui, selon une première variante, comporte les différentes opérations suivantes :
- on met en place, entre les pavés de séparation qui sont d'une pièce avec la structure de précontrainte d'un étage, des modules qui comportent deux blocs actifs de part et d'autre d'un pavé de séparation,
- on applique sur les pavés de séparation de cet étage qui ne sont pas d'une pièce avec la structure de précontrainte une force de précontrainte, qui est dirigée radialement vers l'intérieur dudit étage,
- on positionne sur l'étage ainsi obtenu la structure de précontrainte de l'étage suivant en disposant les pavés de séparation qui sont d'une pièce avec cette structure de précontrainte sur ceux des pavés de séparation de l'étage précédent qui font partie des modules mis en place entre les pavés de séparation qui sont d'une pièce avec la structure de précontrainte dudit étage,
- on soude les pavés de séparation ainsi superposés,
- on supprime la force de précontrainte exercée sur les pavés de l'étage précédent,
- on poursuit l'assemblage du nouvel étage en mettant en place, entre les pavés de séparation qui sont d'une pièce avec sa structure de précontrainte, des modules qui comportent deux blocs actifs de part et d'autre d'un pavé de séparation.

Selon une autre variante :
- on met en place, entre les pavés de séparation qui sont d'une pièce avec la structure de précontrainte d'un étage, des modules qui comportent deux blocs actifs de part et d'autre d'un pavé de séparation,
- on superpose deux étages ainsi obtenus en appliquant une force de précontrainte qui est dirigée radialement vers l'intérieur desdits étages d'une part sur ceux des pavés de séparation de l'un des étages qui ne sont pas d'une pièce avec la structure de précontrainte et d'autre part sur les pavés de séparation de l'autre étage qui sont superposés à ces pavés de séparation précontraints et qui sont d'une pièce avec la structure de précontrainte de cet autre étage,
- on soude les pavés de séparation précontraints ainsi superposés.

D'autres caractéristiques et avantages de l'invention ressortiront encore de la description qui suit qui est purement illustrative et non limitative et qui doit être lue en regard des dessins annexés sur lesquels :
- la figure 1, déjà analysée, est une représentation développée d'une structure active conforme à celle qui a été décrite dans EP 0 908 961A;
- la figure 2 est une représentation développée illustrant le fonctionnement en torsion de la structure active de la figure 1 ;
- les figures 3a à 3c sont des représentations schématiques qui illustrent différentes étapes de la réalisation proposée dans EP 0 908 961A;
- la figure 4 est une représentation semblable à celle de la figure 1 d'une structure d'actionneur conforme à un mode de réalisation possible de l'invention ;
- la figure 5 est une représentation en vue de dessus d'un étage de la structure de la figure 4 ;
- les figures 6a à 6d illustrent le montage d'une structure du type de celle des figures 4 et 5 ;
- les figures 7a et 7b illustrent la disposition des lames qui permettent la mise sous tension des blocs actifs d'une part lorsque la structure est au repos et d'autre part lorsqu'elle est sollicitée en torsion.

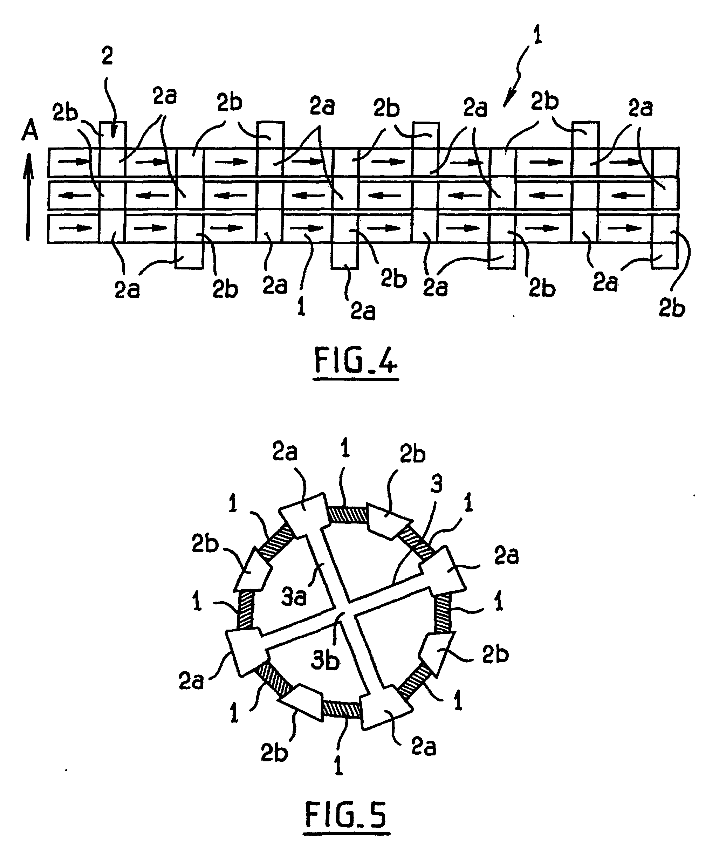

L'actionneur illustré sur la figure 4 comporte une structure générale du même type que celle illustrée sur les figures 1 et 2 et comprend une pluralité de blocs actifs piézo-électriques ou électrostrictifs 1 répartis selon un empilement de plusieurs couches, ainsi qu'une pluralité d'éléments de séparation 2 interposés entre lesdits blocs actifs 1. Le sens de polarisation des blocs 1 est alterné d'une couche d'empilement à l'autre.

Toutefois, contrairement au mode de réalisation proposé par la demanderesse dans sa demande antérieure EP 0 908 961A et décrit ci-dessous en référence aux figures 1, 2 et 3a à 3c, les éléments de séparation 2 successifs dans la hauteur de la structure ne sont pas d'une pièce.

Chaque élément de séparation 2 est constitué de deux pavés 2a, 2b de forme trapézoïdale qui sont assemblés par soudure, chaque pavé 2a, 2b ayant une hauteur qui correspond à la hauteur d'une couche d'empilement de blocs actifs 1.

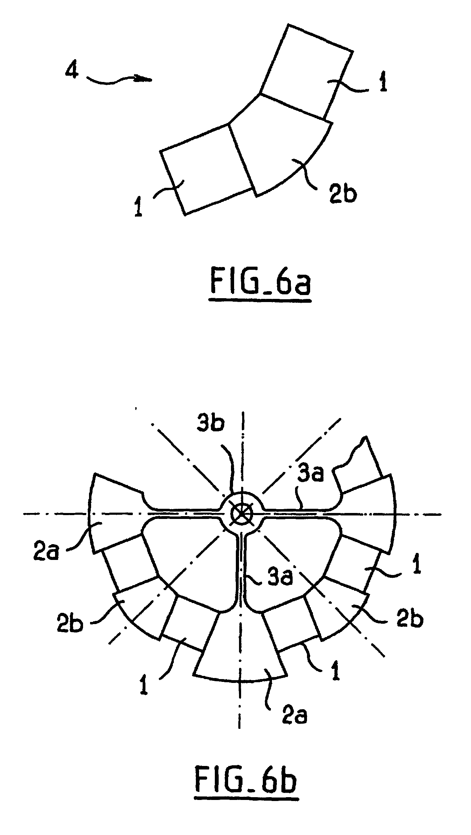

Dans une même couche de l'empilement, les sous 2a alternent avec les pavés 2b. Les pavés 2a d'une même couche d'empilement sont reliés rigidement les uns aux autres par une structure 3 (figure 5) qui s'étend à l'intérieur de l'actionneur et avec laquelle ils sont d'une pièce. Les pavés 2b ne sont quant à eux pas reliés entre eux.

La pièce que constitue la structure 3 et les pavés 2a est destinée à assurer la pré-contrainte des céramiques qui constituent les blocs actifs 1.

Ainsi que l'illustre la figure 5, la structure de précontrainte 3 est avantageusement constituée par une pluralité de bras 3a qui s'étendent radialement en croix (cas d'un actionneur tubulaire comportant huit blocs actifs 1 par étage) - et plus généralement en étoile - entre un élément central 3b et les sous-pavés 2a.

L'élément central 3b a préférentiellement une forme annulaire.

Le montage de l'empilement tubulaire correspondant à la structure illustrée sur la figure 5 se fait de la façon suivante.

Dans en premier temps, on assemble des modules 4 constitués de deux blocs 1 de céramique et d'un pavé trapézoïdal 2b en acier de part et d'autre duquel on dispose les deux blocs 1 (figure 6a).

Puis, on positionne les modules 4 ainsi obtenus entre les pavés trapézoïdaux 2a qui terminent les bras 3a de la structure de liaison en croix.

On applique sur ses pavés trapézoïdaux 2b une force de précontrainte, qui est dirigée radialement vers l'intérieur de la structure tubulaire (figure 6b).

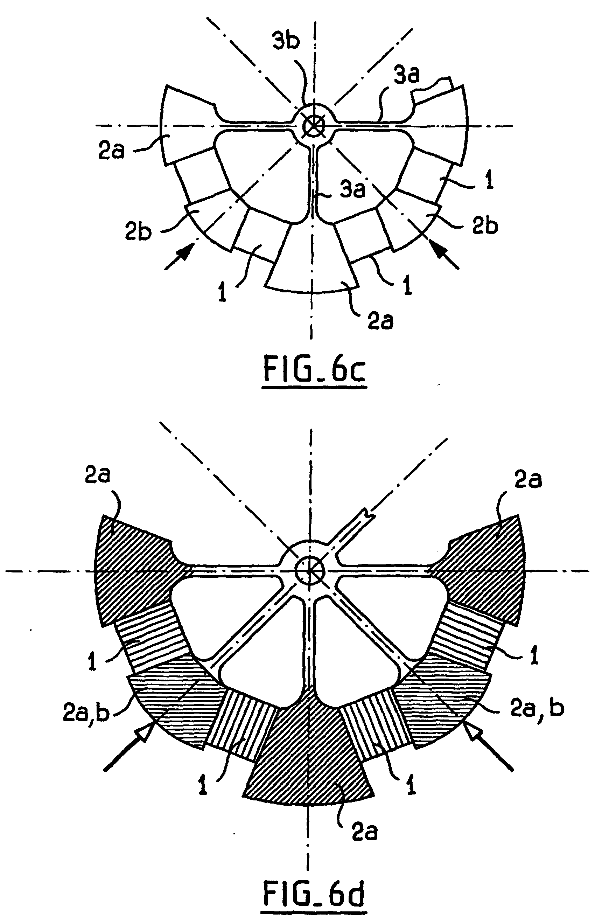

Puis on positionne sur l'étage ainsi obtenu une nouvelle pièce de précontrainte (pavés 2a reliés entre eux par une structure de liaison 3) en disposant les pavés 2a de cette pièce de précontrainte sur les pavés 2b de l'étage précédent. Dans le cas d'un actionneur comportant huit blocs actifs 1 par étage et des pièces de précontrainte en croix, les pièces de précontrainte seront d'un étage à l'autre tournées de 45° (figure 6c).

On soude alors les pavés 2a de ce nouvel étage aux pavés 2b de l'étage précédent (zones hachurées sur la figure 6d).

On libère la précontrainte étalonnée exercée sur ces pavés 2b. On peut alors poursuivre l'assemblage du nouvel étage en insérant entre les pavés 2a du nouvel étage des modules 4 constitués de deux blocs actifs disposés de part et d'autre d'un pavé de séparation 2b.

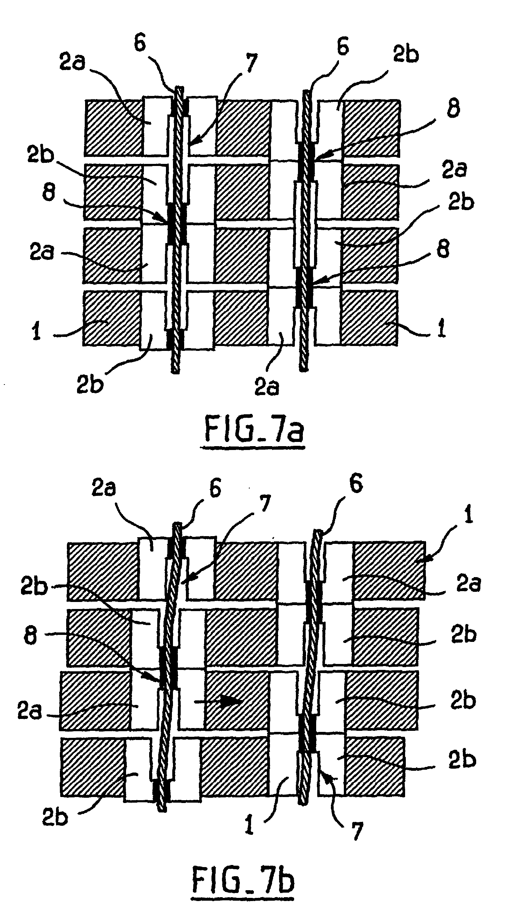

A l'issue de l'assemblage des différents étages, des lames métalliques 6 (figures 7a, 7b) sont soudées sur les pavés métalliques 2a, 2b de façon à permettre d'alimenter chaque étage de l'actionneur.

Ces lames 6 sont reçues dans des encoches 7 que présentent les pavés de séparation 2a, 2b. Ces encoches 7 permettent un débattement desdites lames 6 lorsque la structure est sollicitée en torsion et présentent une largeur et une profondeur choisies à cet effet. Les zones de soudure, référencées par 8, de ces lames 6 sont réparties tous les deux pavés 2a, 2b, la longueur non soudées entre deux zones étant aussi grande que possible. Ces zones de soudure 8 sont alternées dans la hauteur de l'actionneur d'un empilement de pavés de séparation à un autre.

Comme on l'aura compris, un tel montage permet d'éviter les problèmes de dispersion de tolérance rencontrés avec les montages du type de ceux présentés dans EP 0 908 961A.

Notamment, une certaine tolérance de dimensionnement peut être acceptée sur les éléments constitutifs des modules 4. Notamment, un déplacement radial ou tangentiel des blocs 1 et des pavés 2b par rapport à une cote nominale théorique peut être toléré.

En outre, la structure de précontrainte s'étend à l'intérieur des étages de l'actionneur et présente une masse moins importante que des bagues de précontrainte.

Egalement, la solution proposée permet de ne pas avoir à utiliser un alliage à mémoire de forme pour réaliser la structure de précontrainte.

D'autres variantes de procédé de réalisation de la structure proposée par l'invention sont envisageables.

Notamment, on peut superposer deux étages obtenus par assemblage de modules 4 sur des structures de précontrainte, en appliquant une force de précontrainte qui est dirigée radialement vers l'intérieur desdits étages d'une part sur ceux des pavés de séparation de l'un des étages qui ne sont pas d'une pièce avec la structure de précontrainte et d'autre part sur les pavés de séparation de l'autre étage qui sont superposés à ces pavés de séparation précontraints et qui sont d'une pièce avec la structure de précontrainte de cet autre étage. On soude alors les pavés de séparation précontraints ainsi superposés.

Un exemple de dimensionnement possible pour un étage d'une structure d'actionneur proposée par l'invention est le suivant :
- Diamètre interne de l'élément annulaire central 3b de la croix de précontrainte : 6mm
- Diamètre interne de la couronne de céramiques : 15 mm
- Diamètre externe de la couronne de céramique : 22 mm
- Hauteur h de la couronne : 2.3 mm
- Hauteur h de la croix : 2.1 mm
- Largeur des bras de la croix : 1.2 mm
- Hauteur d'un bloc de céramique : 2 mm
- Jeu de fonctionnement entre étages : 0.3 mm
- Longueur (sens actif) d'un bloc de céramique : 4.5 mm
- Largeur d'un bloc de céramique : 3.6 mm.

Le nombre de céramiques par étage est avantageusement de 8, l'actionneur comportant 364 étages.

Les structures de liaison 3 et les pavés 2a, 2b sont réalisés en acier à hautes caractéristiques mécaniques.

Les céramiques utilisées sont soit des céramiques massives, soit des blocs multicouches, telles que des céramiques PZ26 dont la valeur de module d'Young est de 50 000Mpa et dont le taux de déformation est de +/-1^{E-3} et suit un comportement pratiquement linéaire. Le champ électrique nominal est de [-1 500 volts/mm ; + 1500 volts/mm].

Les lames utilisées pour alimenter les structures métalliques sont des lames en phynox de à,4 mm d'épaisseur et de 2 mm de largeur.

## Revendications

1. Actionneur piézo-électrique ou électrostrictif, qui comporte une pluralité d'étages de blocs actifs piézo-électriques ou électrostricifs répartis de façon à former une structure tubulaire, la polarisation des blocs actifs étant alternée d'un étage à l'autre, des éléments de séparation (2a, 2b) séparant deux à deux les blocs actifs élémentaires (1) d'un même étage, ces éléments étant superposés les uns aux autres dans la hauteur de la structure, étant aptes à glisser les uns sur les autres et étant d'une raideur supérieure à celle des blocs actifs élémentaires, un élément de séparation s'étendant sur la hauteur de deux étages de blocs actifs, les éléments de séparation de part et d'autre d'un même bloc actif élémentaire s'étendant respectivement à travers l'un et l'autre des deux étages de part et d'autre dudit bloc actif élémentaire, un élément de séparation étant constitué de deux pavés soudés appartenant chacun à un étage différent, les pavés d'un même étage étant alternativement des pavés qui sont d'une pièce avec une structure de précontrainte (3) qui s'étend à l'intérieur dudit étage et des pavés soudés aux pavés de l'étage précédent qui sont d'une pièce avec la structure de précontrainte de cet autre étage, et des moyens formant électrodes permettant d'appliquer des tensions alternées sur les différents empilements de blocs actifs.

2. Actionneur selon la revendication 1, **caractérisé en ce que** la structure de précontrainte d'un étage a une forme générale en étoile.

3. Actionneur selon la revendication 2, **caractérisé en ce que** le nombre de blocs actifs par étages est de huit et **en ce que** la structure de précontrainte d'un étage a une forme générale en croix.

4. Actionneur selon l'une des revendications précédentes, **caractérisée en ce qu'**un pavé de séparation a une forme générale trapézoïdale.

5. Actionneur selon l'une des revendications précédentes, **caractérisé en ce que** les pavés de séparation sont en matériau métallique.

6. Actionneur selon la revendication 5, **caractérisé en ce que** des lames qui s'étendent dans la hauteur de la structure sont soudées sur les pavés de séparation pour permettre la mise sous tension des blocs actifs.

7. Actionneur selon la revendication 6, **caractérisé en ce que** les lames s'étendent dans des encoches qui autorisent leurs débattement lors de la déformation en torsion de la structure tubulaire.

8. Actionneur selon l'une des revendications 6 ou 7, **caractérisé en ce que** les zones de soudure sont sensiblement réparties tous les deux pavés dans la hauteur d'un empilement de pavés de séparation.

9. Procédé de réalisation d'un actionneur piézo-électrique ou électrostrictif selon l'une des revendications précédentes, comportant les différentes opérations suivantes :
- on met en place, entre les pavés de séparation (2a) qui sont d'une pièce avec la structure de précontrainte (3a, 3b) d'un étage, des modules (4) qui comportent deux blocs actifs (1) de part et d'autre d'un pavé de séparation (2b),
- on applique sur les pavés de séparation (2b) de cet étage qui ne sont pas d'une pièce avec la structure de précontrainte une force de précontrainte, qui est dirigée radialement vers l'intérieur dudit étage,
- on positionne sur l'étage ainsi obtenu la structure de précontrainte de l'étage suivant en disposant les pavés de séparation (2a) qui sont d'une pièce avec cette structure de précontrainte sur ceux des pavés de séparation de l'étage précédent qui font partie des modules mis en place entre les pavés de séparation qui sont d'une pièce avec la structure de précontrainte dudit étage,
- on soude les pavés de séparation ainsi superposés,
- on supprime la force de précontrainte exercée sur les pavés de l'étage précédent,
- on poursuit l'assemblage du nouvel étage en mettant en place, entre les pavés de séparation qui sont d'une pièce avec sa structure de précontrainte, des modules qui comportent deux blocs actifs de part et d'autre d'un pavé de séparation.

10. Procédé de réalisation d'un actionneur piézo-électrique ou électrostrictif selon l'une des revendications 1 à 8, comportant les différentes opérations suivantes
- on met en place, entre les pavés de séparation (2a) qui sont d'une pièce avec la structure de précontrainte (3a, 3b) d'un étage, des modules (4) qui comportent deux blocs actifs (1) de part et d'autre d'un pavé de séparation (2b),
- on superpose deux étages ainsi obtenus en appliquant une force de précontrainte qui est dirigée radialement vers l'intérieur desdits étages d'une part sur ceux des pavés de séparation de l'un des étages qui ne sont pas d'une pièce avec la structure de précontrainte et d'autre part sur les pavés de séparation de l'autre étage qui sont superposés à ces pavés de séparation précontraints et qui sont d'une pièce avec la structure de précontrainte de cet autre étage,
- on soude les pavés de séparation précontraints ainsi superposés.

## Patentansprüche

1. Piezoelektrischer oder elektrostriktiver Antrieb, der folgendes umfaßt: mehrere Stufen aktiver piezoelektrischer oder elektrostriktiver Blöcke, die derart verteilt sind, daß sie eine röhrenförmige Struktur bilden, wobei die Polarisation der aktiven Blöcke sich von einer Stufe zur anderen abwechselt, Trennelemente (2a, 2b), die paarweise die aktiven Grundblöcke (1) einer Stufe trennen, wobei diese Elemente in die Höhe der Struktur übereinander angeordnet sind, und geeignet sind, aufeinander zu gleiten, und eine höhere Steifigkeit als die der aktiven Grundblöcke haben, wobei sich ein Trennelement in die Höhe von zwei Stufen der aktiven Blöcke erstreckt, die Trennelemente beiderseits eines aktiven Grundblockes sich durch die eine bzw. die andere der beiden Stufen beiderseits des aktiven Grundblockes erstrecken, ein Trennelement aus zwei fest miteinander verbundenen Pflasterelementen gebildet ist, die jeweils zu einer anderen Stufe gehören, wobei die Pflasterelemente einer Stufe abwechselnd Pflasterelemente sind, die aus einem Stück mit einer Vorspannstruktur (3) sind, die sich in das Innere der Stufe erstreckt, und Pflasterelemente, die mit den Pflasterelementen der vorhergehenden Stufe fest verbunden sind, die aus einem Stück mit der Vorspannstruktur dieser anderen Stufe sind, und Elektroden bildende Mittel, die es ermöglichen, Wechselspannungen an die verschiedenen Stapel aktiver Blöcke anzulegen.

2. Antrieb nach Anspruch 1, **dadurch gekennzeichnet, daß** die Vorspannstruktur einer Etage im allgemeinen sternförmig ist.

3. Antrieb nach Anspruch 2, **dadurch gekennzeichnet, daß** die Anzahl an aktiven Blöcken pro Stufe gleich 8 ist und daß die Vorspannstruktur einer Stufe im allgemeinen kreuzförmig ist.

4. Antrieb nach einem der vorhergehenden Ansprüche, **dadurch gekennzeichnet, daß** ein Trennpflasterelement eine im allgemeinen trapezförmige Form hat.

5. Antrieb nach einem der vorhergehenden Ansprüche, **dadurch gekennzeichnet, daß** die Trennpflasterelemente aus einem metallischen Material sind.

6. Antrieb nach Anspruch 5, **dadurch gekennzeichnet, daß** Elektroden, die sich in die Höhe der Struktur erstrecken, mit den Trennpflasterelementen fest verbunden sind, damit die aktiven Blöcke unter Spannung gesetzt werden können.

7. Antrieb nach Anspruch 6, **dadurch gekennzeichnet, daß** die Elektroden sich in Aussparungen erstrecken, die ihre Durchfederung während der Torsionsdeformation der röhrenförmigen Struktur ermöglichen.

8. Antrieb nach einem der Ansprüche 6 oder 7, **dadurch gekennzeichnet, daß** die Befestigungsbereiche im wesentlichen über die beiden Pflasterelemente in die Höhe eines Stapels der Trennpflasterelemente verteilt sind.

9. Verfahren zur Herstellung eines piezoelektrischen oder elektrostriktiven Antriebs gemäß einem der vorhergehenden Ansprüche, welches die folgenden verschiedenen Schritte umfaßt:
- zwischen die Trennpflasterelemente (2a), die aus einem Stück mit der Vorspannstruktur (3a, 3b) sind, einer Stufe werden Module (4) montiert, die zwei aktive Blöcke (1) beiderseits eines Trennpflasterelementes (2b) umfassen,
- an die Trennpflasterelemente (2b) dieser Stufe, die nicht aus einem Stück mit der Vorspannstruktur sind, wird eine Vorspannkraft angelegt, die radial in das Innere der besagten Stufe gerichtet ist,
- auf der so erhaltenen Stufe wird die Vorspannstruktur der nachfolgenden Stufe positioniert, indem die Trennpflasterelemente (2a), die aus einem Stück mit dieser Vorspannstruktur sind, auf denjenigen der Trennpflasterelemente der vorhergehenden Stufe angeordnet werden, die Teil von Modulen sind, die zwischen die Trennpflasterelemente montiert sind, die aus einem Stück mit der Vorspannstruktur der besagten Stufe sind,
- die so übereinander angeordneten Trennpflasterelemente werden fest miteinander verbunden,
- die auf die Pflasterelemente der vorhergehenden Stufe ausgeübte Vorspannkraft wird aufgehoben,
- die Montage der neuen Stufe wird fortgeführt, indem zwischen die Trennpflasterelemente, die aus einem Stück mit ihrer Vorspannstruktur sind, Module montiert werden, die zwei aktive Blöcke beiderseits eines Trennpflasterelementes umfassen.

10. Verfahren zum Herstellen eines piezoelektrischen oder elektostriktiven Antriebs gemäß einem der Ansprüche 1 bis 8, das die folgenden verschiedenen Schritte umfaßt:
- zwischen die Trennpflasterelemente (2a), die aus einem Stück mit der Vorspannstruktur (3a, 3b) sind, einer Stufe werden Module (4) montiert, die zwei aktive Blöcke (1) beiderseits eines Trennpflasterelementes (2b) umfassen,
- zwei so erhaltene Stufen werden, indem eine Vorspannkraft angelegt wird, die radial in das Innere der besagten Stufen gerichtet ist, einerseits auf diejenigen der Trennpflasterelemente der einen der Stufen, die nicht aus einem Stück mit der Vorspannstruktur ist, und andererseits auf die Trennpflasterelemente der anderen Stufe, die über diesen Vorspanntrennpflasterelementen angeordnet sind und die aus einem Stück mit der Vorspannstruktur dieser anderen Stufe sind, übereinander angeordnet,
- die so übereinander angeordneten Vorspanntrennpflasterelemente werden fest miteinander verbunden.

## Claims

1. A piezoelectric or electrostrictive actuator which comprises a plurality of stages of piezoelectric or electrostrictive active blocks distributed so as to form a tubular structure, the polarization of the active blocks alternating from one stage to the next, separation elements (2a, 2b) separating the unit active blocks (1) of any one stage in pairs, said elements being superposed on one another in the height direction of the structure, being suitable for sliding over one another, and being of stiffness greater than that of the unit active blocks, a separation element extending over the height of two stages of active blocks, the separation elements on either side of a given unit active block extending respectively through both stages on either side of said unit active block, a separation element being constituted by two bonded-together slabs each belonging to a different stage, the slabs of any one stage alternating between slabs that are integral with a prestress structure (3) which extends inside said stage, and slabs that are bonded to slabs of the preceding stage which are integral with the prestress structure of said other stage, and electrode-forming means enabling voltages of alternating sign to be applied to the various stacks of active blocks.

2. An actuator according to claim 1, **characterized in that** the prestress structure of a stage is generally star-shaped.

3. An actuator according to claim 2, **characterized in that** the number of active blocks per stage is eight, and **in that** the prestress structure of any one stage is generally cross-shaped.

4. An actuator according to any preceding claim, **characterized in that** a separation slab is generally trapezoidal in shape.

5. An actuator according to any preceding claim, **characterized in that** the separation slabs are made of metal.

6. An actuator according to claim 5, **characterized in that** blades which extend in the height direction of the structure are bonded to the separation slabs to enable voltage to be applied to the active blocks.

7. An actuator according to claim 6, **characterized in that** the blades extend in notches leaving them with clearance when the tubular structure is subjected to twisting deformation.

8. An actuator according to claim 6 or 7, **characterized in that** the bonding zones are distributed substantially every other slab in the height direction of a stack of separation slabs.

9. A method of making a piezoelectric or electrostrictive actuator according to any preceding claim, the method comprising the following various operations:
. modules (4) each comprising two active blocks (1) on either side of a separation slab (2b) are installed between the separation slabs (2a) which are integral with the prestress structure (3a, 3b) of a stage;
. a prestress force directed radially towards the inside of the stage is applied to those separation slabs (2b) of said stage that are not integral with the prestress structure;
. the prestress structure of the following stage is positioned on the stage obtained in this way by placing the separation slabs (2a) which are integral with said prestress structure on the separation slabs of the preceding stage which are portions of the modules inserted between the separation slabs that are integral with the prestress structure of said stage;
. the separation slabs superposed in this way are bonded together;
. the prestress force exerted on the slabs of the preceding stage is removed; and
. assembly of the new stage is continued by installing modules, each comprising two active blocks on either side of a separation slab between the separation slabs that are integral with the prestress structure of the new stage.

10. A method of making a piezoelectric or electrostrictive actuator according to any one of claims 1 to 8, the method comprising the following various operations:
. modules (4) each comprising two active blocks (1) on either side of a separation slab (2b) are installed between the separation slabs (2a) which are integral with the prestress structure (3a, 3b) of a stage;
. two stages obtained in this way are superposed while applying a prestress force which is directed radially towards the insides of said stages firstly on those separation slabs of one of the stages which are not integral with the prestress structure, and secondly on the separation slabs of the other stage which are superposed with said prestress separation slabs and which are integral with the prestress structure of said other stage; and
. the prestress separation slabs as superposed in this way are bonded together.
